# FASCICULE DE BREVET EUROPEEN

(11) **EP 4 093 953 B1**
(45) Date de publication et mention de la délivrance du brevet: **02.07.2025**
(21) Numéro de dépôt: 21700774.9
(22) Date de dépôt: 18.01.2021
(51) Int. Cl.: F01M 13/00, F16L 25/01, F16L 53/35, F16L 53/38, H05K 3/10

(54) **DISPOSITIF DE RACCORDEMENT FLUIDIQUE ET DE CHAUFFAGE DE FLUIDE**
FLUIDVERBINDUNG UND FLUIDHEIZVORRICHTUNG
FLUID CONNECTION AND FLUID HEATING DEVICE

(30) Priorité: 20.01.2020 FR 2000529
(43) Date de publication de la demande: 30.11.2022
(73) Titulaire: HUTCHINSON, 75008 Paris (FR)
(72) Inventeur: ASTAFYEVA, Ksenia, 45200 MONTARGIS (FR); BENARD, Thierry, 45430 CHECY (FR)
(74) Mandataire: Gevers & Orès
(86) Numéro de dépôt international: PCT/EP2021/050966
(87) Numéro de publication internationale: WO 2021/148359

(56) Documents cités:
- EP-A1- 1 421 265
- EP-A1- 2 619 495
- WO-A1-2011/139898
- DE-U1- 202009 016 368
- FR-A1- 2 516 439
- FR-A1- 2 994 892
- FR-A1- 3 030 994
- JP-A- S6 233 497
- KR-A- 20160 012 746
- US-A1- 2006 196 448
- US-A1- 2008 099 000
- US-A1- 2013 336 643

## Description

### Domaine technique de l'invention

La présente invention concerne notamment un dispositif de raccordement fluidique et de chauffage de fluide, en particulier pour un véhicule automobile, ce dispositif pouvant par exemple être utilisé pour une application telle que le raccordement d'un embout d'admission d'air à un tuyau de fuite des gaz d'un moteur thermique à combustion interne.

### Arrière-plan technique

Un tuyau de fuite des gaz d'un moteur thermique à combustion interne, pour le passage des gaz de la chambre de combustion au carter du moteur, est largement connu sous l'appellation anglaise « *blow-by* ». D'une manière générale, les connectiques rapides des véhicules automobiles ont pour fonction de connecter les tuyaux de transfert de fluide aux organes du moteur. En particulier, des dispositifs de raccordement et réchauffage de fluide sont utilisés dans des systèmes de dépollution où l'on réinjecte dans le tuyau d'admission d'air les résidus gazeux de la combustion du moteur qui s'accumulent dans le carter moteur et qui contiennent notamment de l'eau. Par grand froid, cette eau peut givrer et entraîner l'obstruction du tuyau, ce qui peut provoquer en cas d'obstruction totale une augmentation de la pression dans le carter moteur conduisant à une évacuation de l'huile de lubrification contenue dans le carter par les prises de jauge de mesure. Il peut en résulter des dommages importants pour le moteur.

Dans la technique actuelle, un tel dispositif de raccordement comprend des moyens de chauffage du fluide. Le fluide à réchauffer circule dans un tube qui est chauffé.

Le document FR-A1-2 943 718 décrit un dispositif de raccordement de fluide pour cette application.

Une autre application pour un dispositif de raccordement fluidique chauffant est un circuit de dépollution SCR (acronyme de l'anglais *Selective Catalytic Reduction*). Dans le document EP-A1-2 363 627, une conduite de fluide comprend un fil chauffant qui est enroulé autour d'un raccord en matière plastique pour cette autre application.

Ces technologies ne sont toutefois pas entièrement satisfaisantes car les dispositifs sont complexes et donc longs et couteux à produire. L'utilisation d'un fil chauffant par exemple nécessite l'enroulement manuel du fil autour du raccord, la qualité de cette opération manuelle ayant un impact sur la qualité du chauffage et se reproductibilité.

Il existe donc un besoin d'un dispositif de raccordement fluidique et de chauffage de fluide qui comprenne un nombre limité de pièces de façon à simplifier sa fabrication et à réduire son coût de fabrication.

### Résumé de l'invention

La présente invention propose un perfectionnement aux technologies précitées qui permet de répondre aux besoins de la technique antérieure.

La présente invention concerne un dispositif de raccordement fluidique et de chauffage de fluide pour un circuit de fluide, en particulier pour un véhicule automobile, ce dispositif comprenant un corps tubulaire monobloc en matériau plastique ou composite comportant :
- une entrée et une sortie équipée chacune de moyens de raccordement fluidique, qui sont du type à emmanchement en force ou à coopération mâle/femelle,
- au moins une surface annulaire interne définissant une veine d'écoulement de fluide depuis l'entrée jusqu'à la sortie du corps, et
- au moins une surface annulaire externe s'étendant autour de la veine et sur laquelle est situé au moins un élément résistif de chauffage, tel que l'élément résistif de chauffage est un circuit résistif qui comprend au moins une piste résistive de forme allongée dont les extrémités longitudinales sont reliées à des bornes de raccordement électrique qui sont surdimensionnées par rapport à la ou chaque piste de façon à être raccordées à des fils ou à des cosses électriques, ledit circuit étant formé *in situ* sur ladite au moins une surface annulaire externe. L'élément résistif se présente ainsi sous la forme d'un circuit qui est directement formé sur au moins une surface annulaire du corps du dispositif. La formation du circuit de chauffage directement sur le corps permet de supprimer l'étape de montage de l'élément résistif de la technologie antérieure, ainsi que les inconvénients qui y sont liés. Cela permet en outre de produire une série de corps avec des circuits de chauffage identiques et donc avec des capacités de chauffage de fluide identiques. La formation *in situ* du circuit permet en outre de supprimer tout espace ou jeu entre l'élément résistif et le corps, qui a tendance à nuire à l'efficacité de chauffage du fluide.

Selon l'invention, le circuit s'étend en continu sur plusieurs surfaces annulaires externes adjacentes.

Les bornes sont également formées directement sur le corps, ce qui facilite le raccordement électrique de la piste. Pour cela, les bornes sont surdimensionnées par rapport à la piste et en particulier sont élargies (elles comprennent une largeur plus importante que celle des pistes) de façon à être chacune aptes à recevoir un point de soudure.

Le dispositif selon l'invention peut comprendre une ou plusieurs des caractéristiques suivantes, prises isolément les unes des autres ou en combinaison les unes avec les autres :
- la piste résistive forme un serpentin ;
- la piste résistive a une largeur inférieure ou égale à 5mm, et par exemple inférieure ou égale à 1mm ;
- les bornes sont soudées aux extrémités de fils électriques ou à des cosses électriques ;
- des cosses électriques sont intégrées au corps et raccordées aux bornes par simple contact ;
- le circuit s'étend tout autour de ladite au moins une surface annulaire externe ;
- ladite au moins une surface annulaire externe est cylindrique ou tronconique ;
- le circuit s'étend sur tout le pourtour d'un fond d'une gorge annulaire ;
- le circuit a une épaisseur inférieure ou égale à 0,5 mm ;
- le circuit s'étend sur une surface représentant au moins 100 mm², et de préférence au moins 250 mm² ;
- le circuit a une longueur comprise entre 5 et 100 mm, et par exemple entre 5 et 50 mm, et un diamètre compris entre 6 et 80 mm ;
- le circuit est configuré pour fournir une puissance thermique comprise entre 0,5 et 10W ; et
- le circuit est au moins partiellement recouvert et protégé par un matériau d'enrobage du corps, par exemple thermoplastique ; et
   -- une couche de passivation ou couche diélectrique recouvre au moins une partie du circuit et en particulier ladite au moins une piste ;
   -- ladite couche de passivation ou couche diélectrique recouvre des points de contact ou de soudure de raccordement des bornes aux fils ou cosses électriques.

La présente invention concerne également un circuit de fluide, en particulier pour un véhicule automobile, comportant au moins un dispositif tel que décrit ci-dessus. Il s'agit par exemple d'un circuit SCR.

La présente invention concerne également un procédé de fabrication d'un dispositif tel que décrit ci-dessus, dans lequel il comprend une étape de réalisation du circuit par une technique choisie parmi l'impression d'une encre résistive ou conductrice et la métallisation sélective.

Une encre résistive est souvent une encre avec une charge semi-conductrice (de type carbone). Ce serait aussi possible de réaliser une piste résistive avec une encre conductrice (chargée du métal) en adaptant par exemple les dimensions de la piste. La métallisation sélective peut être réalisée par laser (optionnel) puis immersion dans un ou plusieurs bains de métallisation (dépôt électrolytique ou non électrolytique). Le laser peut être utilisé pour réaliser une modification chimique de la surface traitée et/ou pour augmenter la rugosité de cette surface.

Le matériau du corps peut comporter un additif destiné à être activé par laser et à faciliter l'accroche d'une ou plusieurs couches de métal lors de l'immersion ou des immersions successives.

Comme alternative, le matériau du corps pourrait ne pas contenir un additif activable par laser et la surface du corps pourrait être activée chimiquement par immersion dans un ou plusieurs bains d'activation chimique avant d'être métallisée.

Le corps peut être réalisé par injection bi-matière dans un moule, d'une première matière ayant une affinité avec un matériau électroconducteur et résistif, et d'une seconde matière non électroconductrice.

L'encre peut être imprimée par jet d'encre, jet d'aérosol, tamponnage, ou toute autre technique adaptée.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig. 1] la figure 1 est une vue schématique en perspective d'un dispositif de raccordement fluidique et de chauffage de fluide selon un mode de réalisation de l'invention ;
[Fig. 2] la figure 2 est une autre vue schématique en perspective du dispositif de la figure 1 ;
[Fig. 2a] la figure 2a est une vue très schématique en coupe d'un dispositif et montre plus spécifiquement le raccordement électrique d'un fil à une borne du circuit résistif du dispositif ;
[Fig. 2b] la figure 2b est une vue très schématique en coupe d'un dispositif et montre plus spécifiquement le raccordement électrique d'une cosse à une borne du circuit résistif du dispositif ;
[Fig. 3] la figure 3 est une vue schématique à plus grande échelle d'un détail du dispositif de la figure 1 ;
[Fig. 4] la figure 4 est une vue schématique en perspective d'un dispositif de raccordement fluidique et de chauffage de fluide selon une variante de réalisation de l'invention ;
[Fig. 5] la figure 5 est une vue schématique en perspective d'un dispositif de raccordement fluidique et de chauffage de fluide recouvert d'un matériau d'enrobage ; et
[Fig. 6a-6f] Les figures 6a à 6f sont des vues très schématiques d'un corps plastique injecté en cours de métallisation, et illustre un procédé de métallisation par LDS ;
[Fig. 7a-7e] Les figures 7a à 7e sont des vues très schématiques d'un corps plastique en cours de métallisation, et illustre un procédé de métallisation sélective assistée par laser (étape optionnelle) avec une étape d'activation chimique ; et
[Fig. 8] la figure 8 est vue très schématique d'un corps plastique en cours de métallisation, et illustre un procédé de métallisation par injection bi-matière.

### Description détaillée de l'invention

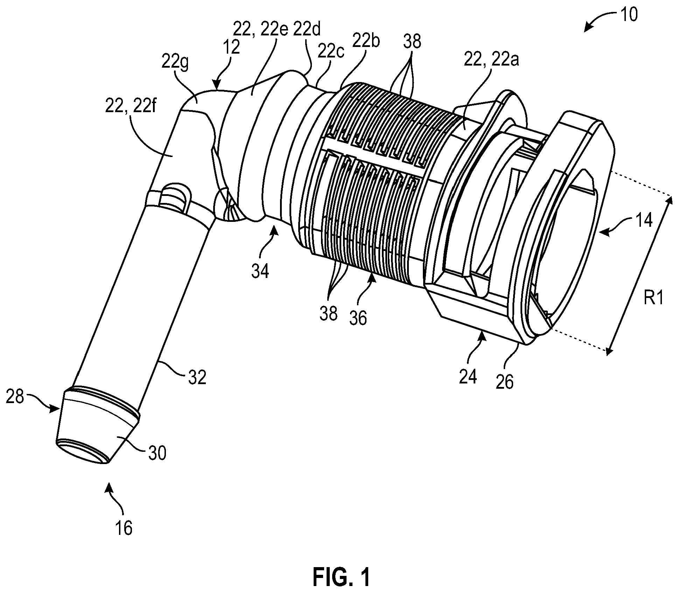

Les figures 1 à 3 illustrent un mode de réalisation d'un dispositif 10 selon l'invention de raccordement fluidique et de chauffage de fluide. Le dispositif 10 est particulièrement conçu pour être utilisé dans un véhicule automobile.

Le fluide peut être un gaz ou un liquide. Il s'agit par exemple de carburant, d'un liquide de refroidissement, d'un gaz de fuite d'un moteur thermique à combustion interne, etc.

Le dispositif 10 fait partie d'un circuit de fluide tel qu'un circuit d'alimentation de carburant, un circuit de climatisation, un circuit de frein à vide, un circuit SCR, etc. Comme sa dénomination l'indique, le dispositif 10 a une double fonction de raccordement fluidique et de chauffage du fluide qu'il achemine.

Pour assurer le raccordement fluidique, il comprend naturellement des moyens de raccordement fluidique et, pour assurer le chauffage, il comprend des moyens de chauffage.

Le dispositif 10 comprend un corps 12 qui a une forme générale tubulaire et qui est monobloc. Ce corps 12 peut avoir une forme droite ou coudé, comme dans l'exemple représenté. Il est monobloc, c'est-à-dire qu'il est formé d'une seule pièce, même si des éléments supplémentaires tels que des éléments de fixation pourraient être rapportés et fixés sur le corps 12.

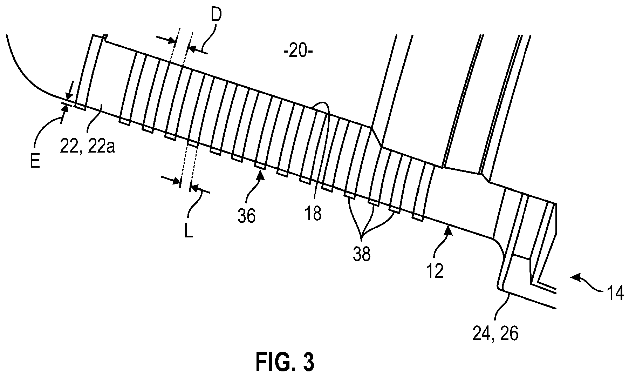

Le corps est réalisé en matériau plastique ou composite, et par exemple en thermoplastique en particulier. Il peut être fabriqué par injection-moulage par exemple. Le corps 12 comprend une entrée de fluide 14 et une sortie de fluide 16. Le corps 12 comprend en outre une ou plusieurs surfaces annulaires internes 18 qui définissent une veine 20 d'écoulement du fluide depuis l'entrée 14 jusqu'à la sortie 16 du corps. La figure 3 est une vue en coupe du dispositif 10 et permet de voir une de ces surfaces 18.

Dans l'exemple représenté, le dispositif 10 et donc le corps 12 sont coudés et la dimension transversale du corps 12 varie, et en particulier diminue, depuis l'entrée 14 jusqu'à la sortie 16. On comprend donc que les surface internes 18 ne sont pas toutes coaxiales et de même diamètre.

Le corps 12 comprend plusieurs surfaces annulaires externes 22 qui s'étendent autour de la veine 20 depuis l'entrée 14 jusqu'à la sortie 16 du corps 12.

Un premier moyen 24 de raccordement fluidique est situé à l'entrée 14 du corps 12 et comprend une cage 26 formant une partie femelle et destinée à recevoir un embout formant une partie mâle. Cette cage 26 est configurée pour coopérer avec un organe de verrouillage destiné à empêcher une désolidarisation accidentelle de l'embout vis-à-vis du dispositif 10. Un ou plusieurs joints d'étanchéité peuvent assurer l'étanchéité du raccordement. Ce type de raccordement fluidique est bien connu de l'homme du métier.

Un second moyen 28 de raccordement fluidique est situé à la sortie 16 du corps 12 et est du type à fixation sapin, qui comprend ici une seule nervure annulaire d'ancrage 30 en saillie sur un tronçon 32 du corps 12. Ce tronçon 32 du corps 12 est destiné à être engagé en force dans l'extrémité d'un tuyau et la nervure d'ancrage 30 est configurée pour assurer un maintien de ce tronçon dans le tuyau. Ce type de raccordement fluidique est bien connu de l'homme du métier.

Depuis la cage 26 jusqu'au tronçon 32, le corps 12 comprend plusieurs surfaces 22 et successivement une surface cylindrique 22a, une ou plusieurs surface(s) annulaire(s) 22b (22c, 22d) définissant une gorge annulaire 34, une surface tronconique 22e, et une autre surface cylindrique 22f. La liaison de la surface tronconique 22e a la surface cylindrique 22f est réalisée au niveau du coude du corps 12 par l'intermédiaire d'une surface 22g en portion de sphère.

Les moyens de chauffage comprennent au moins un élément résistif de chauffage situé sur au moins une des surfaces 22a-22f du corps 10.

Selon l'invention, l'élément résistif de chauffage est un circuit résistif 36 qui est formé *in situ* sur au moins une des surfaces 22a-22f du corps 10.

Le circuit 36 est ainsi formé directement sur le corps 10. Dans le mode préféré de réalisation de l'invention où le circuit 36 comprend au moins une piste résistive 38 de forme allongée dont les extrémités longitudinales sont reliées à des bornes 40 de raccordement électrique, la piste 38 et les bornes 40 sont formées directement sur le corps 12.

Le matériau conducteur et résistif du circuit 36 est donc au contact du matériau du corps 12 qui n'est toutefois pas conducteur. Il est toutefois envisageable de prévoir une couche de passivation ou couche diélectrique entre le circuit 36 et le corps 12. Une telle couche de passivation peut en variante ou en caractéristique additionnelle être prévue sur le circuit 36 afin de le protéger de l'atmosphère extérieur.

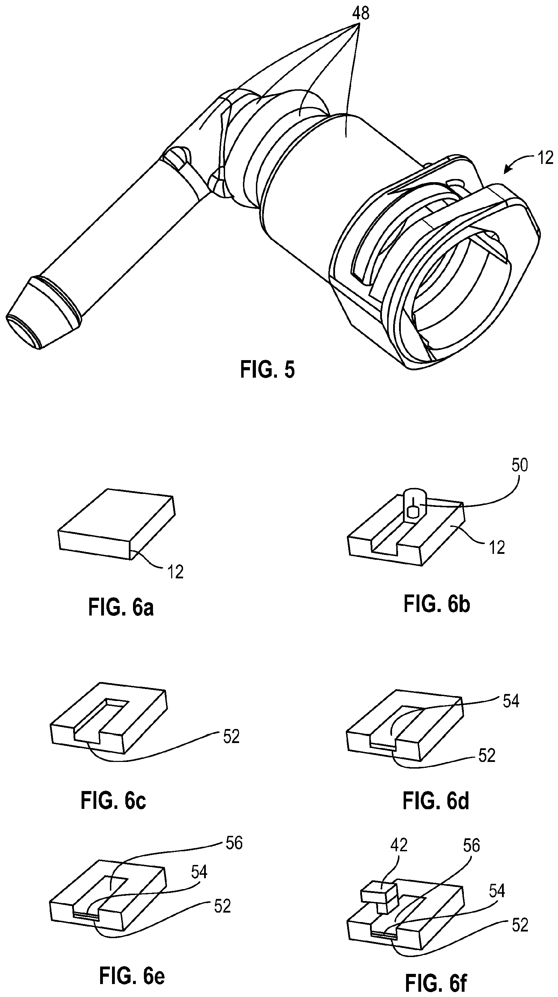

Le corps 12 peut être enrobé dans un matériau d'enrobage 48, par exemple un thermoplastique élastique, comme cela est visible à la figure 5. Ce matériau d'enrobage 48 recouvre et protège le circuit 36.

Comme évoqué dans ce qui précède, une ou plusieurs pistes 38 s'étendent entre les bornes 40. Dans l'exemple représenté, une seule piste 38 a ses extrémités longitudinales reliées aux bornes 40. Cette piste 38 forme avantageusement un serpentin avec plusieurs lignes droites (et incurvées du fait de la forme annulaire des surfaces 22 du corps 12) et plusieurs allers-retours en U.

La ou chaque piste 38 peut avoir une longueur supérieure ou égale à 5mm, voire 100mm, voire encore plus. La ou chaque piste 38 (ou portion de piste) peut avoir une largeur L supérieure ou égale à 80µm, et de préférence supérieure ou égale à 100 µm (figure 3). Cette largeur est de préférence inférieure ou égale à 5mm. La ou chaque piste 38 peut avoir une épaisseur inférieure ou égale à 10 µm (figure 3).

Chaque portion de la ou de chaque piste 38 peut être agencée de façon à toujours être distante d'une distance D comprise entre 100µm et 5 mm d'une ou des portion(s) de piste adjacente ou de la ou des borne(s) (figure 3).

Dans un exemple particulier de réalisation de l'invention, L≤D≤80 mm. La distance minimale entre deux portions ou tours de piste peut être comparable à la largeur L de la piste, qui est par exemple d'environ 100-300µm.

Les bornes 40 peuvent avoir une forme générale rectangulaire dont les dimensions sont par exemple 1mm x 1mm ou 1mm x 2mm.

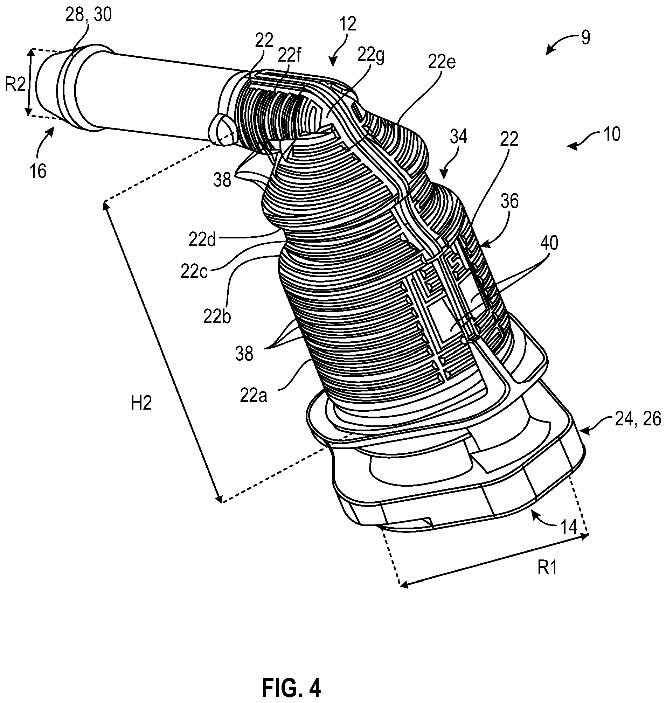

Le mode de réalisation des figures 1 à 3 montre une piste résistive 38 qui s'étend entre les bornes 40 et sur la surface 22a, et en particulier sur tout son pourtour. La variante de réalisation de la figure 4 montre une piste résistive 38 qui s'étend entre les bornes 40 tout autour des surfaces 22a-22f y compris au fond de la gorge 34.

Le circuit 36 peut s'étendre sur une surface ou aire représentant au moins 10 cm². Le circuit 36 peut avoir une longueur H1, H2 comprise entre 5 et 100 mm, et un diamètre R1, R2 compris entre 6 et 80 mm. Le circuit 36 peut être configuré pour fournir une puissance thermique comprise entre 0,5 et 10W. Le dispositif 10 peut être chauffé pour avoir une température maximale comprise entre 20 et 90°C environ, et de préférence entre 40 et 60°C.

Dans les exemples représentés, les bornes 40 sont situées à proximité l'une de l'autre, sur la surface 22a. Elles sont de préférence réalisées dans le même matériau conducteur et résistif que la piste 38.

Ces bornes 40 servent à raccorder électriquement le circuit 36 à un dispositif de contrôle et de commande du chauffage (non représenté). Le raccordement peut être réalisé par l'intermédiaire de deux fils conducteurs 42 dont des extrémités longitudinales sont soudées respectivement sur les bornes 40. On comprend donc que les bornes 40 sont avantageusement dimensionnées pour recevoir un point de soudure 44 d'une extrémité d'un des fils 42. Les bornes 40 sont donc surdimensionnées par rapport à la piste 38, et en particulier élargies.

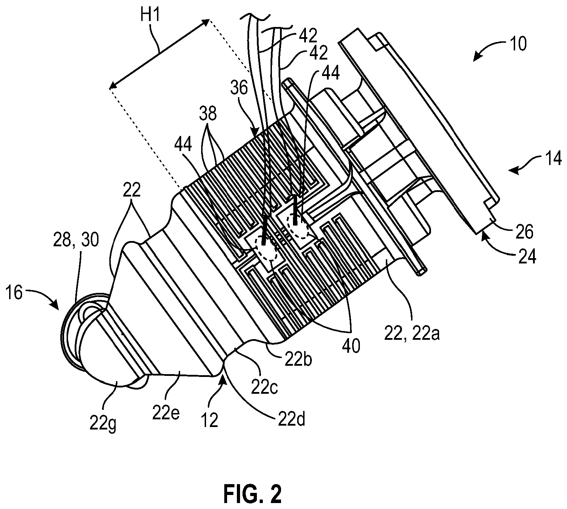

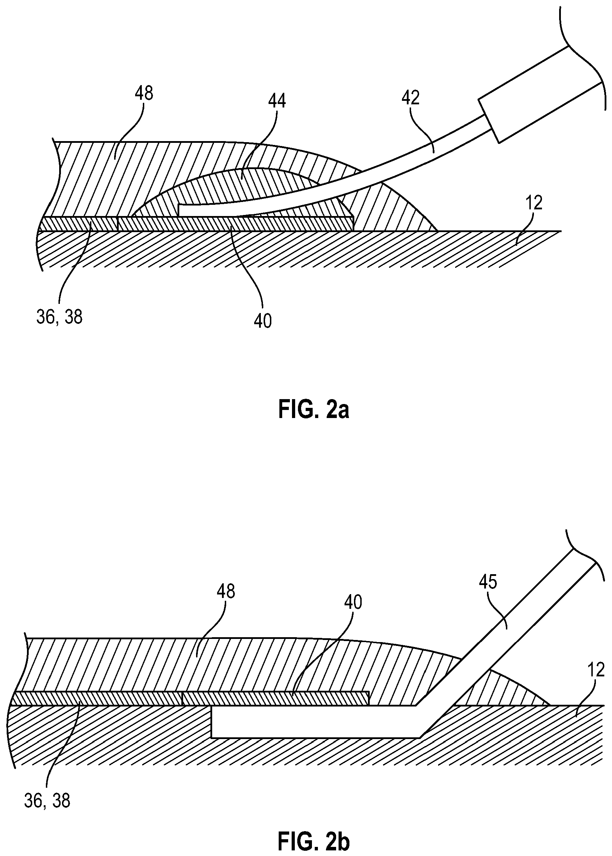

Dans le cas précité où une couche de passivation recouvre le circuit 36, on comprend que, si cette couche est déposée avant le raccordement électrique des bornes 40, la couche de passivation sera déposée sur la piste 38 et ne sera pas déposée sur les bornes pour permettre le dépôt des points de soudure 44. Si la couche de passivation est déposée après le raccordement électrique des bornes, cette couche pourra recouvrir les pistes ainsi que les points de soudure. Dans le cas précité de l'utilisation d'un matériau d'enrobage 48, celui-ci peut être conçu pour assurer un maintien des points 44 et des fils 42 sur le corps 12. La figure 2a illustre un mode de réalisation montrant ces caractéristiques.

La figure 2b illustre une variante dans laquelle le raccordement électrique des bornes électriques à un fil ou à une cosse n'est pas réalisé par soudure (figure 1) mais par simple contact. Dans le cas illustré à la figure 2b, le contact est réalisé en intégrant la cosse 45 dans le corps 12 du dispositif puis en déposant ou formant la piste 38 et la borne 40 sur le corps et la cosse. Le circuit et la zone de contact de la borne 40 sur la cosse 45 sont alors revêtus par le matériau d'enrobage 48.

Le circuit 36 peut être formé *in situ* sur le corps de plusieurs manières, et en particulier par une technique de plastronique. La plastronique regroupe l'ensemble des techniques d'impression d'électronique imprimée ou de métallisation sélective sur un substrat rigide en matière plastique ou composite et à trois dimensions, et est également connue sous la dénomination MID (qui est l'acronyme de l'anglais *Molded Interconnect Device).*

Le circuit 36 peut être réalisé par exemple par une technique choisie parmi l'impression d'une encre résistive ou conductrice et la métallisation sélective.

L'encre peut être imprimée par impression jet d'encre par exemple.

La métallisation sélective peut être réalisée par injection bi-matière, d'une première matière électroconductrice et résistive et d'une seconde matière non électroconductrice, dans un moule de fabrication du corps. On comprend que la première matière formera les pistes 38 et les bornes 40 et la seconde matière formera le reste du corps 12.

En variante, la première matière pourrait ne pas être conductrice mais comprendre seulement un additif (tels que des germes de cuivre) facilitant l'accrochage du circuit 36.

En variante, la métallisation sélective peut être réalisée par la technologie LDS (gravure directe par laser ou *Laser Direct Structuring* en anglais) qui est une des technologies de MID qui permet de produire des pistes sur des pièces injectées complexes. Le corps 12 est fabriqué à partir d'une matière incorporant un additif organométallique (figure 6a). Ensuite, un faisceau laser 50 grave directement les pistes pour activer la matière grâce à un procédé physicochimique entre l'additif et le laser (figure 6b). Pour les circuits fins, la métallisation est réalisée par dépôt non-électrolytique. Une fois cette matière activée, le corps est plongé dans différents bains contenant des ions de métal (cuivre, après nickel, puis or) pour réaliser plusieurs dépôts successifs 52, 54, 56 de métal dans la zone activée (figures 6c-6e). Les couches successives sont par exemple du type Cu/Ni/Au, Cu/Ni/Ag, Cu/Ni/(Pd/Au), Ni/Pd/Au, Cu/Ni, Cu/Sn, etc. La dernière étape consiste à souder les fils 42 comme évoqué dans ce qui précède (figure 6f).

Les épaisseurs des couches métalliques sont par exemple ;
- Cu = 15 µm max (de préférence, entre 4 et 10 µm)
- Ni = 20 µm max (de préférence, inférieure à 15 µm)
- Au = 1 µm max (normalement, 0.11µm avec tolérance de ± 0.05µm)

Les couches relativement épaisses (supérieures à 15µm dans le cas de cuivre) sont fabriquées par dépôt électrolytique, i.e. galvanoplastie.

Les polymères métallisables sont des polymères thermoplastiques, polymères à cristaux liquides (LCP en anglais), certaines résines thermodurcissables et certains élastomères réticulés. Pour les applications qui nécessitent une résistance à des hautes températures (110-150°C), les thermoplastiques de type PA et PPA, PPS sont préférables.

Un polymère compatible avec LDS comprend en général un additif apte à produire des germes à la surface du corps en étant activée par laser. Il peut s'agir d'un oxyde cuivre-chrome (CuO·Cr₂O₃) ou d'un complexe organique de Cu ou de Pd. Généralement, un polymère de ce type comprend entre 1 et 15% en poids d'additif LDS, le reste étant formé par la matrice polymère et d'éventuelles charges renforçantes.

Plusieurs matériaux sont actuellement disponibles sur le marché pour des applications LDS, parmi lesquels le matériau TECACOMP^{®} PEEK LDS black 3980 commercialisé par la société Ensinger, et le matériau Preperm 260 LDS
(PPE) commercialisé par la société Premix.

Il existe également des peintures métallisables. La peinture est pulvérisée sur un polymère conventionnel (sans additif LDS) pour le rendre métallisable.

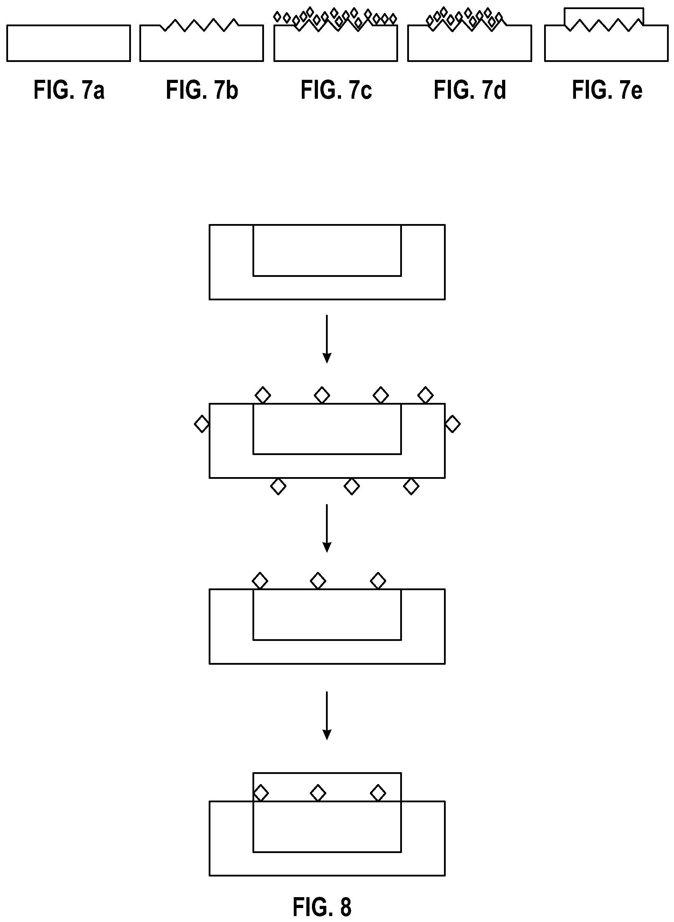

En variante, la première matière pourrait ne pas être conductrice et ne pas contenir un additif activable par laser. La rugosité de la surface du corps pourrait être augmentée par un traitement laser. L'activation de la surface pourrait être réalisée chimiquement, comme cela est illustrée aux figures 7a (injection plastique par exemple), 7b (activation par laser optionnel), 7c (activation chimique), 7d (rinçage pour le nettoyage sélectif des particules de la surface non activée), et 7e (métallisation sélective non électrolytique). A titre d'exemple, cette activation pourrait être réalisée par un traitement du corps avec une solution de colloïdes (technologie *Laser Induced Selective Activation,* LISA), typiquement du chlorure de Pd-Sn. Un autre exemple consiste à utiliser une solution non-colloïde (technologie *Selective Surface Activation by Laser,* SSAIL), tel que du nitrure d'Ag. Le corps est ensuite rincé afin d'enlever des particules de solution d'activation de la surface non-traitée, puis est métallisé par immersion dans un bain chimique de métallisation (selon le protocole précédent).

Un autre type de métallisation est la métallisation appelée injection bi-matière (*Two Shot Molding* ou *2K Molding* en anglais), qui est illustrée à la figure 8 (de haut en bas, injection bi-matière, activation chimique, rinçage sélectif et métallisation sélective). La pièce plastique est moulée en deux injections successives, par un matériau métallisable et un matériau classique. Le premier plastique est traité à l'aide d'un mordant chimique (tel qu'un acide de chrome ou hydroxyde de potassium), puis le circuit est déposé par voie liquide similaire à la technique LDS (dépôt non-électrolytique préféré). Les métaux utilisés, l'épaisseur du circuit fabriqué et le contrôle du procédé sont similaires à ceux de la technique LDS.

Ces technologies de plastronique permettent de rapporter la fonction de chauffage directement sur le corps en plastique en diminuant le nombre de composants (fils) ce qui abaisse le coût surtout celui de main d'œuvre.

Il y a d'autres techniques de métallisation sélective, comme celles connues sous les dénominations anglosaxonnes *Hot Embossing* ou Plasmacoat 3D^{®}. La première technique peut mettre en forme des motifs métalliques par estampillage sur des polymères avec une faible température de transition vitreuse (Tg). Quant à Plasmacoat 3D^{®}, Il s'agit de la pulvérisation d'un métal au travers d'une torche de plasma. Cette méthode permettant de déposer des motifs métalliques en cuivre ou zinc par exemple.

## Revendications

1. Dispositif (10) de raccordement fluidique et de chauffage de fluide pour un circuit de fluide, en particulier pour un véhicule automobile, ce dispositif comprenant un corps tubulaire (12) monobloc en matériau plastique ou composite comportant :
- une entrée (14) et une sortie (16) équipées chacune de moyens de raccordement fluidique, qui sont du type à emmanchement en force ou à coopération mâle/femelle,
- au moins une surface annulaire interne (18) définissant une veine (20) d'écoulement de fluide depuis l'entrée (14) jusqu'à la sortie (16) du corps, et
- au moins une surface annulaire externe (22) s'étendant autour de la veine et sur laquelle est situé au moins un élément résistif de chauffage,
l'élément résistif de chauffage étant un circuit résistif (36) qui comprend au moins une piste résistive (38) de forme allongée dont les extrémités longitudinales sont reliées à des bornes (40) de raccordement électrique qui sont surdimensionnées par rapport à la ou chaque piste de façon à être raccordées à des fils ou à des cosses électriques, ledit circuit étant formé *in situ* sur ladite au moins une surface annulaire externe, **caractérisé en ce que** le circuit (36) s'étend en continu sur plusieurs surfaces annulaires externes (22a-22f) adjacentes du corps tubulaire (12).

2. Dispositif (10) selon la revendication 1, dans lequel la piste résistive (38) forme un serpentin.

3. Dispositif (10) selon la revendication 1 ou 2, dans lequel la piste résistive (38) a une largeur (L) inférieure ou égale à 5mm, et par exemple inférieure ou égale à 1mm.

4. Dispositif (10) selon l'une des revendications précédentes, dans lequel le circuit (36) s'étend tout autour de ladite au moins une surface annulaire externe (22).

5. Dispositif (10) selon l'une des revendications précédentes, dans lequel ladite au moins une surface annulaire externe (22) est cylindrique ou tronconique.

6. Dispositif (10) selon l'une des revendications précédentes, dans lequel le circuit (36) s'étend sur tout le pourtour d'un fond d'une gorge annulaire (34).

7. Dispositif (10) selon l'une des revendications précédentes, dans lequel le circuit (36) a une épaisseur (E) inférieure ou égale à 0,5 mm.

8. Dispositif (10) selon l'une des revendications précédentes, dans lequel le circuit (36) s'étend sur une surface représentant au moins 100 mm², et de préférence au moins 250 mm².

9. Dispositif selon l'une des revendications précédentes, dans lequel le circuit (36) a une longueur (H1, H2) comprise entre 5 et 100 mm, et un diamètre (R1, R2) compris entre 6 et 80 mm.

10. Dispositif (10) selon l'une des revendications précédentes, dans lequel le circuit (36) est au moins partiellement recouvert et protégé par un matériau d'enrobage du corps, par exemple thermoplastique.

11. Circuit de fluide, par exemple SCR, en particulier pour un véhicule automobile, comportant au moins un dispositif (10) selon l'une des revendications précédentes.

12. Procédé de fabrication d'un dispositif selon l'une des revendications 1 à 10, dans lequel il comprend une étape de réalisation du circuit (36) par une technique choisie parmi l'impression d'une encre résistive ou conductrice et la métallisation sélective.

13. Procédé selon la revendication 12, dans lequel la métallisation sélective est réalisée par laser puis immersion dans un ou plusieurs bains de métallisation.

14. Procédé selon la revendication 13, dans lequel le matériau du corps comporte un additif destiné à être activé par laser et à faciliter l'accroche d'une ou plusieurs couches de métal lors de l'immersion ou des immersions successives.

15. Procédé selon la revendication 13 ou 14, dans lequel le corps est réalisé par injection bi-matière dans un moule, d'une première matière ayant une affinité avec un matériau électroconducteur et résistif, et d'une seconde matière non électroconductrice.

16. Procédé selon la revendication 12, dans lequel l'encre est imprimée par jet d'encre ou jet d'aérosol ou tamponnage.

## Patentansprüche

1. Vorrichtung (10) zum fluidischen Anschluss und zum Erhitzen eines Fluids für einen Fluidkreis, insbesondere für ein Kraftfahrzeug, wobei diese Vorrichtung einen einstückigen rohrförmigen Körper (12) aus Kunststoffmaterial oder Verbundwerkstoff umfasst, umfassend:
- einen Einlass (14) und einen Auslass (16), die jeweils mit Mitteln zum fluidischen Anschluss ausgestattet sind, die vom Aufpress- oder männlich/weiblich zusammenwirkenden Typ sind,
- mindestens eine ringförmige innere Fläche (18), die einen Fluidströmungskanal (20) vom Einlass (14) bis zum Auslass (16) des Körpers definiert, und
- mindestens eine ringförmige äußere Fläche (22), die sich um den Kanal herum erstreckt und auf der sich mindestens ein Heizwiderstandselement befindet,
wobei das Heizwiderstandselement ein Widerstandskreis (36) ist, der mindestens eine Widerstandsspur (38) von länglicher Form umfasst, deren Längsenden mit elektrischen Anschlussklemmen (40) verbunden sind, die in Bezug auf die oder jede Spur so überdimensioniert sind, dass sie an elektrische Drähte oder Kabelschuhe angeschlossen werden können, wobei der Kreis in situ auf der mindestens einen ringförmigen äußeren Fläche gebildet ist, **dadurch gekennzeichnet, dass** sich der Kreis (36) durchgehend über mehrere aneinandergrenzende ringförmige äußere Flächen (22a-22f) des rohrförmigen Körpers (12) erstreckt.

2. Vorrichtung (10) nach Anspruch 1, wobei die Widerstandsspur (38) eine Schlange bildet.

3. Vorrichtung (10) nach Anspruch 1 oder 2, wobei die Widerstandsspur (38) eine Breite (L) von kleiner oder gleich 5 mm, und zum Beispiel kleiner oder gleich 1 mm, aufweist.

4. Vorrichtung (10) nach einem der vorstehenden Ansprüche, wobei sich der Kreis (36) ganz um die mindestens eine ringförmige äußere Fläche (22) herum erstreckt.

5. Vorrichtung (10) nach einem der vorstehenden Ansprüche, wobei die mindestens eine ringförmige äußere Fläche (22) zylindrisch oder kegelstumpfförmig ist.

6. Vorrichtung (10) nach einem der vorstehenden Ansprüche, wobei sich der Kreis (36) über den gesamten Umfang eines Bodens einer ringförmigen Nut (34) erstreckt.

7. Vorrichtung (10) nach einem der vorstehenden Ansprüche, wobei der Kreis (36) eine Dicke (E) von kleiner oder gleich 0,5 mm aufweist.

8. Vorrichtung (10) nach einem der vorstehenden Ansprüche, wobei sich der Kreis (36) über eine Fläche erstreckt, die mindestens 100 mm², und bevorzugt mindestens 250 mm² ausmacht.

9. Vorrichtung nach einem der vorstehenden Ansprüche, wobei der Kreis (36) eine Länge (H1, H2) im Bereich zwischen 5 und 100 mm und einen Durchmesser (R1, R2) im Bereich zwischen 6 und 80 mm aufweist.

10. Vorrichtung (10) nach einem der vorstehenden Ansprüche, wobei der Kreis (36) mindestens teilweise von einem Überzugsmaterial des Körpers, zum Beispiel Thermoplast, bedeckt und geschützt ist.

11. Fluidkreis, zum Beispiel SCR, insbesondere für ein Kraftfahrzeug, der mindestens eine Vorrichtung (10) nach einem der vorstehenden Ansprüche umfasst.

12. Verfahren zur Herstellung einer Vorrichtung nach einem der Ansprüche 1 bis 10, wobei es einen Schritt der Herstellung des Kreises (36) durch eine Technik umfasst, die aus dem Druck einer Widerstands- oder leitenden Tinte und der selektiven Metallisierung ausgewählt ist.

13. Verfahren nach Anspruch 12, wobei die selektive Metallisierung durch Laser, dann Eintauchen in ein oder mehrere Metallisierungsbäder hergestellt wird.

14. Verfahren nach Anspruch 13, wobei das Material des Körpers ein Zusatzmittel umfasst, das dazu vorgesehen ist, durch Laser aktiviert zu werden und das Haften einer oder mehrerer Metalllagen bei dem Eintauchen oder den aufeinanderfolgenden Eintauchvorgänge zu erleichtern.

15. Verfahren nach Anspruch 13 oder 14, wobei der Körper durch Injektion zweier Werkstoffen in eine Gussform, eines ersten Werkstoffs, der eine Affinität mit einem elektrisch leitenden und Widerstandsmaterial aufweist, und eines zweiten Werkstoffs, der nicht elektrisch leitend ist, hergestellt wird.

16. Verfahren nach Anspruch 12, wobei die Tinte durch Tintenstrahl oder Aerosolstrahl oder Stempeldruck aufgedruckt wird.

## Claims

1. A fluidic connection and fluid heating device (10) for a fluid circuit, in particular for a motor vehicle, this device comprising a one-piece tubular body (12) made of plastic or composite material comprising:
- an inlet (14) and an outlet (16) each equipped with fluidic connection means, which are of the press-fit or male/female cooperation type,
- at least one internal annular surface (18) defining a fluid flow duct (20) from the inlet (14) to the outlet (16) of the body, and
- at least one external annular surface (22) extending around the duct and on which is located at least one resistive heating element,
the resistive heating element being a resistive circuit (36) which comprises at least one elongated resistive track (38) whose longitudinal ends are connected to electric connection terminals (40) which are oversized relative to the or each track so as to be connected to electrical wires or lugs, said circuit being formed *in situ* on said at least one external annular surface,
**characterized in that** the circuit (36) extends continuously over a plurality of adjacent external annular surfaces (22a-22f) of the tubular body (12).

2. The device (10) of claim 1, wherein the resistive track (38) forms a serpentine.

3. The device (10) of claim 1 or 2, wherein the resistive track (38) has a width (L) less than or equal to 5mm, and for example less than or equal to 1mm.

4. The device (10) of any of the preceding claims, wherein the circuit (36) extends all-around said at least one external annular surface (22).

5. The device (10) according to any of the preceding claims, wherein said at least one external annular surface (22) is cylindrical or frustoconical.

6. The device (10) of any preceding claims, wherein the circuit (36) extends over the entire circumference of a bottom of an annular gorge (34).

7. The device (10) according to any of the preceding claims, wherein the circuit (36) has a thickness (E) less than or equal to 0.5 mm.

8. The device (10) according to any of the preceding claims, wherein the circuit (36) extends over a surface area of at least 100 mm², and preferably at least 250 mm².

9. The device according to any of the preceding claims, wherein the circuit (36) has a length (H1, H2) of between 5 and 100 mm, and a diameter (R1, R2) of between 6 and 80 mm.

10. The device (10) of any of the preceding claims, wherein the circuit (36) is at least partially covered and protected by a coating material of the body, for example thermoplastic.

11. A fluid circuit, for instance SCR, in particular for a motor vehicle, comprising at least one device (10) according to one of the preceding claims.

12. A method for manufacturing a device according to any of claims 1 to 10, wherein it comprises a step of realizing the circuit (36) by a technique selected from printing a resistive or conductive ink and the selective metallization.

13. The method of claim 12, wherein the selective metallization is realized by laser followed by immersion in one or more metallization baths.

14. The method of claim 13, wherein the material of the body comprises an additive intended to be laser activated and to facilitate the attachment of one or more metal layers during the immersion or the successive immersions.

15. The method according to claim 13 or 14, wherein the body is made by two-material injection into a mould, of a first material having an affinity for an electrically conductive and resistive material, and a second, non-electrically conductive material.

16. The method of claim 12, wherein the ink is printed by inkjet or aerosol jet or stamping.
